# EUROPÄISCHE PATENTANMELDUNG

(11) **EP 4 600 996 A1**
(43) Veröffentlichungstag der Anmeldung: **13.08.2025**
(21) Anmeldenummer: 24155973.1
(22) Anmeldetag: 06.02.2024
(51) Int. Cl.: H01L 21/67, H01L 21/673

(54) **VORRICHTUNG UND VERFAHREN ZUM TROCKNEN VON SCHEIBENFÖRMIGEN SUBSTRATEN**

(71) Anmelder: Siltronic AG, 81677 München (DE)
(72) Erfinder: Reeske, Gregor, 09599 Freiberg (DE); Kühnstetter, Albert, 84489 Burghausen (DE)
(74) Vertreter: Hasenhütl, Eva

(57) **Zusammenfassung**

Vorrichtung zum Trocknen von scheibenförmigen Substraten (8) umfassend einen Körper (1) mit einer horizontalen Haupterstreckungsrichtung (2) und einem Querschnittsprofil (3) quer zur Haupterstreckungsrichtung (2), das sich in vertikaler Richtung nach oben verjüngt,
wobei der Körper (1) an seiner Oberseite mehrere Auflagepositionen (5) aufweist, die dafür geeignet sind, scheibenförmige Substrate (8) abzustützen,
die mehreren Auflagepositionen (5) entlang der Haupterstreckungsrichtung (2) angeordnet sind,
an die mehreren Auflagepositionen (5) Flächen des Körpers angrenzen, die ausgehend von den Auflagepositionen (5) abfallen, und
zumindest ein Teil der an die Auflagepositionen (5) angrenzenden, abfallenden Flächen zumindest in einem Teil (7) ihres oberen Abschnitts hydrophil ist und eine periodische Mikrostruktur aufweist.

## Beschreibung

### Technisches Gebiet

Gegenstand der vorliegenden Erfindung sind eine Vorrichtung zum Trocknen von scheibenförmigen Substraten und ein Verfahren zum Trocknen von scheibenförmigen Substraten.

### Stand der Technik

Scheiben aus Halbleitermaterial, beispielsweise Scheiben aus monokristallinem Silizium (Siliziumwafer), werden in einer Vielzahl von Prozessschritten hergestellt, die unter anderem das Ziehen eines Einkristallstabs aus einer Schmelze, das Zersägen des Kristalls in Scheiben, das Schleifen, das Kantenverrunden, das Polieren und das chemische Reinigen der Scheiben umfassen. Durch die chemische Reinigung werden Verunreinigungen entfernt und die Oberflächen der Scheiben passiviert. Eine Form der chemischen Reinigung ist die Nassreinigung, die eine anschließende Trocknung der Scheiben erfordert.

Im Rahmen der chemischen Reinigung werden die scheibenförmigen Substrate für einige Zeit in ein oder mehrere Bäder mit einer Flüssigkeit getaucht und dann so langsam entnommen, dass so wenig Flüssigkeitsreste wie möglich an den Substraten haften bleiben. Grund dafür ist, dass die an den scheibenförmigen Substraten anhaftenden Flüssigkeitsreste eine Quelle für Verunreinigungen darstellen und die Qualität der Oberfläche des scheibenförmigen Substrats, vor allem im Randbereich, signifikant beeinflussen können. Flüssigkeitsreste, die zunächst zwischen dem Scheibenhalter und einem Substrat haften, können sich auf den Seitenflächen des Substrats ausbreiten und nach dem Trocknen Partikel auf dem Substrat hinterlassen. Da die Flüssigkeitsreste schwerflüchtige Verbindungen wie Metallpartikel enthalten können, bleiben die Verunreinigungen auch nach dem Verdampfen der Flüssigkeit auf der Scheibenoberfläche zurück.

Zum Trocknen von in Flüssigkeit getauchten, scheibenförmigen Substraten bietet sich ein Verfahren an, in dessen Verlauf die Substrate aus der Flüssigkeit in einen Gasraum überführt werden, der Dampf enthält, der auf den Substraten nicht kondensiert und die Oberflächenspannung der auf den Substraten haftenden Flüssigkeitsresten herabsetzt. Das Verfahren und der damit genutzte physikalische Effekt sind in der EP0385536 A1 beschrieben, ebenso wie eine Vorrichtung, die zur Durchführung eines solchen Verfahrens geeignet ist.

Weitere Vorrichtungen und Verfahren zur Verbesserung der Reinigungsqualität in Bezug auf verbleibende Partikel auf dem scheibenförmigen Substrat werden auch in den Dokumenten DE 10 2014 207 266 A1, EP 3 840 021 A1, EP 3 840 022 A1 und EP 3 840 023 A1 beschrieben. Bei der Anwendung dieser Vorrichtungen und Verfahren bleiben jedoch nach dem Trocknen immer noch Partikel auf der Oberfläche der scheibenförmigen Substrate zurück, die die Qualität der scheibenförmigen Substrate mindern. Aufgabe der vorliegenden Erfindung ist es, die im Stand der Technik beschriebenen Vorrichtungen und Verfahren zum Trocknen weiter zu verbessern und so die Anzahl von Partikeln zu verringern, die auf den getrockneten scheibenförmigen Substraten zurückbleiben.

### Technische Aufgabe der Erfindung und deren Lösung

Ziel der vorliegenden Erfindung ist es deshalb, eine Vorrichtung und ein Verfahren zur Trocknung von scheibenförmigen Substraten bereitzustellen, die es ermöglichen, die Flüssigkeitsreste, und damit die in der Flüssigkeit enthaltenen Partikel, die an den scheibenförmigen Substraten haften, besser und effizienter zu entfernen.

Die Aufgabe wird dabei erfindungsgemäß gelöst durch eine Vorrichtung zum Trocknen von scheibenförmigen Substraten gemäß dem ersten Aspekt der vorliegenden Erfindung.

Diese Vorrichtung umfasst einen Körper mit einer horizontalen Haupterstreckungsrichtung und einem Querschnittsprofil quer zur Haupterstreckungsrichtung, das sich in vertikaler Richtung nach oben verjüngt,
wobei der Körper an seiner Oberseite mehrere Auflagepositionen aufweist, die dafür geeignet sind, scheibenförmige Substrate abzustützen,
die mehreren Auflagepositionen entlang der Haupterstreckungsrichtung angeordnet sind,
an die mehreren Auflagepositionen Flächen des Körpers angrenzen, die ausgehend von den Auflagepositionen abfallen, und
zumindest ein Teil der an die Auflagepositionen angrenzenden, abfallenden Flächen zumindest in einem Teil ihres oberen Abschnitts hydrophil ist und eine periodische Mikrostruktur aufweist.

Es wurde überraschend festgestellt, dass durch die Ausgestaltung der an die Auflagepositionen angrenzenden, von den Auflagepositionen aus abfallenden Flächen mit einem oberen Abschnitt, der hydrophil ist und eine Mikrostruktur aufweist, Flüssigkeitsreste schneller und effizienter entfernt werden können und so die Menge an Verunreinigungen auf der Oberfläche eines scheibenförmigen Substrates weiter verringert werden kann.

Gemäß dem zweiten Aspekt ist die vorliegende Erfindung auf ein Verfahren zum Trocknen von scheibenförmigen Substraten, die in eine Flüssigkeit getaucht sind, gerichtet. Das Verfahren umfasst die folgenden Schritte:
das Positionieren der in die Flüssigkeit getauchten, scheibenförmigen Substrate auf der Vorrichtung gemäß dem ersten Aspekt der vorliegenden Erfindung; und
das Überführen der scheibenförmigen Substrate mit der Vorrichtung aus der Flüssigkeit in einen Gasraum enthaltend einen Dampf, der auf den scheibenförmigen Substraten nicht kondensiert und die Oberflächenspannung von Flüssigkeitsresten, die an den scheibenförmigen Substraten haften, herabsetzt.

In diesem Verfahren können Flüssigkeitsreste zwischen den scheibenförmigen Substraten und der Vorrichtung, die die Scheiben abstützt, über die an die Auflagepositionen angrenzenden, nach unten geneigten Flächen des Körpers ablaufen und so entfernt werden. Es kann also darauf verzichtet werden, die Flüssigkeitsreste zwischen den scheibenförmigen Substraten und den Scheibenhalter aktiv zu entfernen.

Dadurch, dass der obere Abschnitt hydrophil ausgestaltet ist, können wässrige Flüssigkeitsreste oder Flüssigkeitsreste mit polaren Lösungsmittelanteilen, die sich am unteren Rand der scheibenförmigen Substrate angesammelt haben, an den Auflagepositionen leichter auf die angrenzenden, nach unten abfallenden Flächen des Körpers übergehen. Es wurde zudem überraschend festgestellt, dass Flüssigkeitsreste, insbesondere Wasser, von einer hydrophilen Oberfläche mit einer periodischen Mikrostruktur aufgrund der wirkenden Kapillarkräfte besser aufgenommen und abgeleitet werden.

Aufgrund der periodische Mikrostruktur und der Hydrophilie zumindest im oberen Abschnitt der an die Auflagepositionen angrenzenden, abfallenden Flächen können Flüssigkeitsreste, die am unteren Rand der auf den Körper abgestützten Scheiben haften, leichter auf die an die Auflagepositionen angrenzenden Flächen übergehen und über die abfallenden, hydrophilen, mikrostrukturierten Flächen von den Auflagepositionen abgeführt werden. Dies ermöglicht eine effiziente Entfernung von Flüssigkeitsresten von den scheibenförmigen Substraten. Dadurch kann die Anzahl der nach der Trocknung auf den scheibenförmigen Substraten verbliebenen Partikel verringert werden. Außerdem wird durch das verbesserte Abfließen der Flüssigkeitsreste bei der Entnahme der Substrate aus dem Bad die Nettoentnahme an Reinigungsflüssigkeit weiter verringert, da ein größerer Anteil der Flüssigkeit in das Reinigungsbad zurückfließt, anstatt zu verdampfen. Dies erhöht die Wirtschaftlichkeit der chemischen Reinigung. Außerdem kann durch das verbesserte Abfließen der Flüssigkeitsreste die Menge an Flüssigkeit, die von der Substratoberfläche verdampft reduziert werden, was zu einer Verbesserung der Atmosphäre im Reinraum führt.

### Kurzbeschreibung der Figuren

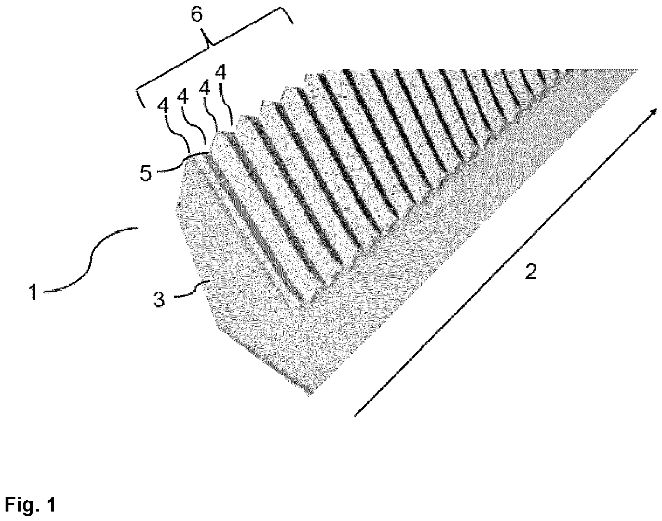

**Fig. 1** zeigt einen Körper (1) einer erfindungsgemäßen Vorrichtung zum Trocknen scheibenförmiger Substrate. Der Körper hat ein Querschnittsprofil (3) quer zur Haupterstreckungsrichtung (2), das sich in vertikaler Richtung nach oben verjüngt. Der Körper hat an seiner Oberseite ein durch eine Zick-Zack-Form gekennzeichnetes Kantenprofil (6), dass entlang der Haupterstreckungsrichtung (2) verläuft. Die einzelnen in Haupterstreckungsrichtung aneinanderstoßenden Kanten (4) bilden tiefer liegende Knicke (5), die als Auflageposition für die scheibenförmigen Substrate dienen.

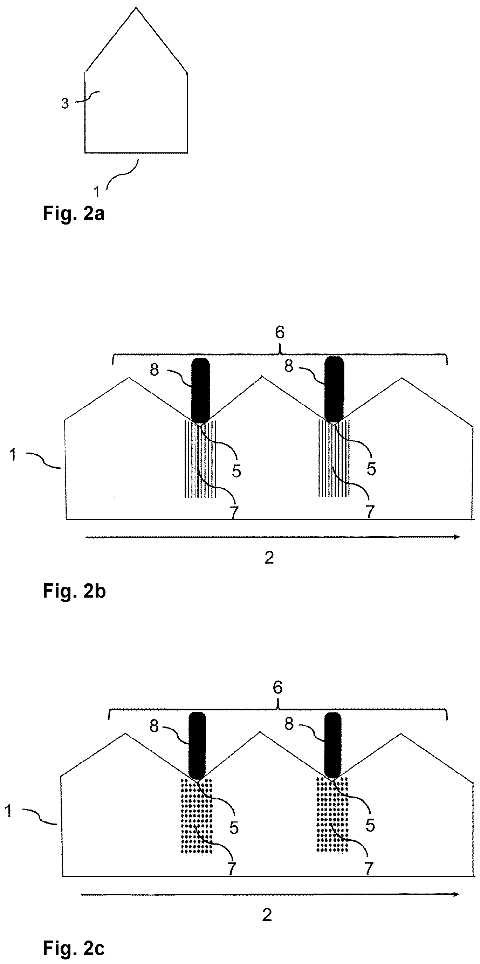

**Fig. 2a** zeigt das Querschnittsprofil (3) und **Fig. 2b** und **Fig. 2c** das Längsprofil entlang der Haupterstreckungsrichtung (2) eines Körpers (1) einer erfindungsgemäßen Vorrichtung. **Fig. 2b** und **Fig. 2c** zeigen jeweils, dass zumindest ein Teil der an die Auflagepositionen (5) für die scheibenförmigen Substrate (8) angrenzenden, abfallenden Flächen zumindest in einem Teil (7) ihres oberen Abschnitts eine periodische Mikrostruktur aufweisen.

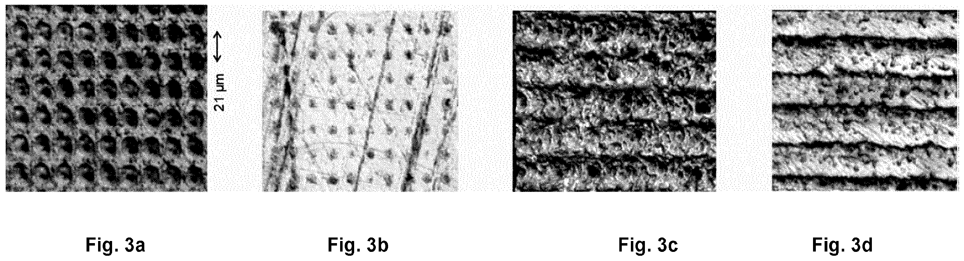

Fig. 3 a-d zeigen rasterkraftmikroskopische Aufnahmen der periodischen Mikrostrukturen, die in den Ausführungsbeispiel 1 bis 4 auf die an die Auflagepositionen angrenzenden Flächen des Körpers einer erfindungsgemäßen Vorrichtung aufgebracht wurden. Diese vier Mikrostrukturen weisen eine Periode von 21 µm und eine Profitiefe im Bereich von 1 µm bis 20 µm auf.

### Detaillierte Beschreibung der Erfindung

Scheibenförmige Substrate im Sinne der vorliegenden Erfindung sind beispielsweise Scheiben aus Halbleitermaterial, vorzugsweise Scheiben aus einkristallinem Silizium, das wahlweise dotiert ist. Die scheibenförmigen Substrate haben vorzugsweise einen Durchmesser von 150 bis 450 mm, besonders bevorzugt 200 mm oder 300 mm, am meisten bevorzugt 300 mm. Die Dicke der scheibenförmigen Substrate liegt vorzugsweise im Bereich von 500 µm bis 1500 µm, vorzugsweise 600 µm bis 1000 µm.

Die erfindungsgemäße Vorrichtung zum Trocknen von scheibenförmigen Substraten gemäß dem ersten Aspekt der vorliegenden Erfindung umfasst einen Körper mit einer horizontalen Haupterstreckungsrichtung und einem Querschnittsprofil quer zur Haupterstreckungsrichtung, das sich in vertikaler Richtung nach oben verjüngt. Vorzugsweise ist das Querschnittsprofil symmetrisch in Bezug auf eine vertikale Symmetrieachse. Vorzugsweise weist das Querschnittsprofil des Körpers in seinem oberen Teil einen spitzen Winkel auf. In diesem Fall bildet der Scheitelpunkt des spitzen Winkels als höchsten Punkt des Querschnittsprofils den Auflagepunkt zur Abstützung des scheibenförmigen Substrats.

Vorzugsweise verjüngt sich der Körper in vertikaler Richtung nach oben zu einer Kante oder einem Kantenprofil. Das Kantenprofil besteht aus mehreren aneinanderstoßenden Kanten, die vorzugsweise in derselben Ebene liegen, vorzugsweise in einer Ebene senkrecht zum Querschnittsprofil. An jeder Kante des Kantenprofils stoßen zwei von der Kante aus abfallenden Flächen aneinander. Die Punkte, an denen jeweils zwei Kanten (4) des Kantenprofils (6) aneinanderstoßen werden im Folgenden als Knicke (5) bezeichnet. Beispielsweise kann das Kantenprofil (6) des Körpers (1) ein Zick-Zack-Profil sein, wie in Fig. 1, Fig. 2b und Fig. 2c dargestellt. Das Kantenprofil (6) verläuft dabei vorzugsweise entlang der Haupterstreckungsrichtung (2). Dies bedeutet, dass das Kantenprofil (6) und die Haupterstreckungsrichtung (2) in derselben Ebene liegen, welche vorzugsweise senkrecht zum Querschnittsprofil (3) angeordnet ist.

Der Körper (1) weist an seiner Oberseite mehrere Auflagepositionen (5) auf, die dafür geeignet sind, scheibenförmige Substrate (8) abzustützen, wobei die mehreren Auflagepositionen entlang der Haupterstreckungsrichtung (2) angeordnet sind und an Flächen des Körpers (1) angrenzen, die ausgehend von den Auflagepositionen (5) abfallen (siehe Fig. 2b und 2c). Die Auflagepositionen (5) werden vorzugsweise durch eine oder mehrere Kanten an der Oberseite des Körpers gebildet, wobei an jeder Kante zwei abfallende Flächen aneinanderstoßen. Vorzugsweise werden die Auflagepositionen (5) durch Kanten gebildet, an denen von der Kante aus abfallende Flächen des Körpers aneinanderstoßen. Zumindest ein Teil der an die Auflagepositionen (5) angrenzenden, abfallenden Flächen ist zumindest in einem Teil (7) ihres oberen Abschnitts hydrophil und weist in diesem Teil eine periodische Mikrostruktur auf. Vorzugsweise weisen alle an die Auflagepositionen (5) angrenzenden abfallenden Flächen zumindest einen Teil (7) ihres oberen Abschnitts auf, der hydrophil ist und eine periodische Mikrostruktur hat. In einer bevorzugten Ausführungsform ist der Teil (7) des oberen Abschnitts, der hydrophil ist und eine periodische Mikrostruktur aufweist, hydrophiler als die Oberfläche einer Scheibe aus einkristallinem Silizium. In einer Ausführungsform, die in Fig. 2b und Fig. 2c dargestellt ist, hat der Teil (7) des oberen Abschnitts der an die Auflagepositionen angrenzenden, abfallenden Flächen, welcher hydrophil ist und eine periodische Mikrostruktur aufweist, eine rechteckige Form.

Unter dem Teil des oberen Abschnitts, der hydrophil ist und eine periodische Mikrostruktur aufweist, ist dabei die Fläche zu verstehen die sowohl hydrophil ist als auch eine periodische Mikrostruktur aufweist. Wenn also, in einer Ausführungsform, die an die Auflagepositionen angrenzenden, abfallenden Flächen vollständig hydrophiliert sind, beispielsweise indem der gesamte Körper einer Gasphasenfluorierung unterzogen wurde, so ist unter dem Teil des oberen Abschnitts, der hydrophil ist und eine periodische Mikrostruktur aufweist, nur derjenige Teil der vollständig hydrophilierten Seitenfläche zu verstehen, der eine periodische Mikrostruktur aufweist. Der Teil des oberen Abschnitts, der hydrophil ist und eine periodische Mikrostruktur aufweist ist also die Schnittmenge der Flächen, die einerseits hydrophil und andererseits mit einer periodischen Mikrostruktur versehen sind. Eine hydrophile Oberfläche im Sinne der vorliegenden Erfindung ist vorzugsweise dadurch gekennzeichnet ist, dass ein Wassertropfen auf ihr einen Kontaktwinkel α von nicht mehr als 50° aufweist.

Die an die Auflagepositionen angrenzenden, abfallenden Flächen können auch so ausgestaltet sein, dass sie einen oberen Abschnitt und einen unteren Abschnitt aufweisen, und der obere Abschnitt hydrophiler als der untere Abschnitt ist.

Wenn sich der Körper in vertikaler Richtung nach oben zu einer Kante verjüngt, beispielsweise wenn der Körper als keilförmiger Körper ausgestaltet ist, dient die nach oben weisende Kante zur Auflage der scheibenförmigen Substrate. In diesem Fall stellt die eine, nach oben weisende Kante mehrere Auflagepositionen bereit. Wenn sich der Körper in vertikaler Richtung nach oben zu einem Kantenprofil verjüngt, werden die Auflagepositionen vorzugsweise durch Knicke im Kantenprofil gebildet, besonders bevorzugt durch die nach unten weisenden Knicke. Wenn das Kantenprofil ein Zick-Zack-Profil ist, dienen vorzugsweise die Knicke als Auflageposition für die scheibenförmigen Substrate, von denen aus zwei Kanten nach oben verlaufen. Eine Auflageposition kann also auch durch zwei Kanten gebildet werden, die an der Oberseite des Körpers entlang der Haupterstreckungsrichtung verlaufen, aneinander angrenzen, und eine unterschiedliche Neigung in Bezug auf die Horizontale aufweisen. In diesem Fall grenzen vier abfallende Flächen an die Auflageposition an.

Die Auflageposition können auch als Aussparung an der Oberseite des Körpers quer zur Haupterstreckungsrichtung ausgestaltet sein. Die Aussparung kann das Verrutschen oder Kippen des an der Auflageposition gestützten scheibenförmigen Substrates entlang der Haupterstreckungsrichtung verringern oder ganz vermeiden, insbesondere wenn die scheibenförmigen Substrate quer zur Haupterstreckungsrichtung angeordnet sind. Die Ausdehnung der einzelnen Aussparungen entlang der Haupterstreckungsrichtung übersteigt dabei die Dicke der scheibenförmigen Substrate, so dass diese in die Aussparungen eingesetzt und durch diese quer zur Haupterstreckungsrichtung gestützt werden können. Die Aussparungen verlaufen vorzugsweise in Querrichtung, also senkrecht zur Haupterstreckungsrichtung und senkrecht zur Vertikalen. Die Aussparungen können dabei quaderförmig, abgeschrägt, V-förmig oder an ihrer Unterseite abgerundet sein.

An die Auflagepositionen grenzen Flächen des Körpers an, die ausgehend von den Auflagepositionen nach unten abfallen. Zumindest ein Teil dieser Flächen weist zumindest in einem Teil ihres oberen Abschnitts eine Oberfläche auf, die hydrophil ist und eine periodische Mikrostruktur hat. Vorzugsweise weisen alle an die Auflagepositionen angrenzenden, abfallenden Flächen zumindest in einem Teil ihres oberen Abschnitts einen Bereich auf, der hydrophil ist und eine periodische Mikrostruktur hat. In einer besonders bevorzugten Ausführungsform ist der gesamte oberen Abschnitt aller an die Auflagepositionen angrenzenden, abfallenden Flächen hydrophil und mit einer Mikrostruktur versehen.

Der Körper kann aus Metall, Keramik oder Kunststoff bestehen. Vorzugsweise besteht der Körper aus einem thermoplastischen Kunststoff, am meisten bevorzugt aus einem hochtemperaturbeständigen thermoplastischen Kunststoff. Der thermoplastische Kunststoff kann beispielsweise ein Polyaryletherketon, vorzugsweise Polyetheretherketon (PEEK), sein. PEEK weist eine hohe chemische Beständigkeit, Verschleißfestigkeit und gute Gleiteigenschaften auf. Der Körper der erfindungsgemäßen Vorrichtung zum Trocknen von scheibenförmigen Substraten besteht also vorzugsweise aus PEEK.

Der obere Abschnitt grenzt dabei vorzugsweise an die Auflageposition an. Vorzugsweise grenzen an jede Auflageposition, die vorzugsweise durch eine oder mehrere Kanten gebildet wird, mindestens zwei nach unten abfallende Flächen mit jeweils einem oberen Abschnitt an, der hydrophil ist und eine periodische Mikrostruktur aufweist. Vorzugsweise sind die mindestens zwei nach unten abfallende Flächen an gegenüberliegenden Seiten ausgehend von der jeweiligen Auflageposition angeordnet.

Eine nach unten abfallende Fläche im Sinne der vorliegenden Erfindung kann beispielsweise eine Neigung von mehr als 10° und weniger als 80° in Bezug auf die Vertikale haben. Eine abfallende Fläche im Sinne der vorliegenden Erfindung kann auch gekrümmt oder gewölbt sein. Abfallend im Sinne der vorliegenden Erfindung bedeutet, dass der an die Auflageposition angrenzende Teil der Fläche weiter oben liegt als ein weiter von der Auflageposition entfernter Teil der Fläche. Somit können Flüssigkeitsreste mit Hilfe der Schwerkraft über die abfallenden Flächen von den auf den Auflagepositionen abgestützten Substraten abgeführt werden.

Der obere Abschnitt grenzt vorzugsweise direkt an eine Auflageposition des Körpers an. Dadurch, dass der obere Abschnitt hydrophil ausgestaltet ist, können wässrige Flüssigkeitsreste, beispielsweise in Form von Tropfen, leichter vom unteren Randbereich der vom Körper abgestützten, scheibenförmigen Substrate auf den Körper übertragen werden und so vom Substrat entfernt werden. Vorzugsweise ist der hydrophile, obere Abschnitt der an die Auflagepositionen angrenzenden, abfallenden Flächen dadurch gekennzeichnet, dass ein Wassertropfen auf ihm einen Kontaktwinkel α von nicht mehr als 50°, besonders bevorzugt nicht mehr als 45°, am meisten bevorzugt nicht mehr als 40° aufweist. In einer Ausführungsform der vorliegenden Erfindung ist der hydrophile, obere Abschnitt der an die Auflagepositionen angrenzenden, abfallenden Flächen so ausgestaltet, dass ein Wassertropfen auf ihm einen Kontaktwinkel von nicht weniger als 20° und nicht mehr als 30° hat.

Vorzugsweise ist die Oberfläche im oberen Abschnitt der an die Auflagepositionen angrenzenden, nach unten abfallende Flächen des Körpers hydrophiler als die Oberfläche des scheibenförmigen Substrates, insbesondere hydrophiler als die Oberfläche eines scheibenförmigen Substrates aus einkristallinem Silizium. In diesem Fall können wässrige Flüssigkeitsreste vom Substrat zum oberen Abschnitt abfließen. Außerdem wird in diesem Fall eine sich bei der Trennung von Substrat und Körper ausbildende Wasserbrücke zum hydrophileren Körper, beziehungsweise zum hydrophileren oberen Abschnitt der an die Auflageposition angrenzenden, abfallenden Fläche, gezogen und somit vom Substrat entfernt. Durch die Schwerkraft und durch Kapillarkräfte fließen diese Flüssigkeitsreste dann über die abfallenden Flächen des Körpers ab.

Die Hydrophilie ist ein Maß für die Benetzbarkeit. Eine hydrophilere Oberfläche hat also eine bessere Benetzbarkeit in Bezug auf Wasser. In der vorliegenden Erfindung wird der Kontaktwinkel α eines Wassertropfens, besonders bevorzugt eines Tropfens entionisierten Wassers, als Maß für die Hydrophilie der Oberfläche herangezogen.

Der Kontaktwinkel α kann gemäß dem folgenden Verfahren bestimmt werden:
(i) Benetzen mindestens einer Stelle einer Fläche, vorzugsweise mindestens einer Stelle des oberen Abschnittes einer abfallenden Fläche des Körpers, mit jeweils einem Tropfen einer Flüssigkeit;
(ii) Aufnehmen eines Bildes jedes Tropfens, vorzugsweise eines Schattenbildes;
(iii) Bestimmen der Kontur des jeweiligen Tropfens ausgehend von dem jeweiligen Bild, vorzugsweise dem Schattenbild, mittels einer geeigneten Software; und
(iv) Bestimmen des Kontaktwinkels zwischen der Oberfläche und dem jeweiligen Tropfen ausgehend von der bestimmten Kontur des jeweiligen Tropfens.

Im Schritt (i) wird die zu untersuchende Stelle der Oberfläche mi einem Wassertropfen, vorzugsweise mit einem Tropfen entionisierten Wassers, benetzt. Im Schritt (ii) wird ein Bild des Tropfens, vorzugsweise ein Schattenbild, mit Hilfe einer Kamera aufgenommen. Im Schritt (iii) wird dann die Kontur des Tropfens ausgehend von dem Bild mittels einer geeigneten Software bestimmt. Dabei kann mittels einer Graustufenanalyse des Bildes eine Konturerkennung durchgeführt werden und anschließend ein die Tropfenkontur beschreibendes, geometrisches Modell identifiziert werden. Die Identifikation des die Tropfenkontur beschreibenden, geometrischen Modells kann beispielsweise durch Fitten erfolgen. Der Kontaktwinkel ergibt sich aus dem Winkel zwischen der ermittelten Tropfenkontur-Funktion und der Oberfläche der untersuchten Stelle, deren Projektion im Tropfenbild als Basislinie bezeichnet werden kann. Als die Tropfenkontur beschreibende geometrische Modelle können beispielsweise Kreis, Kegelschnitt, Ellipse oder Polynome herangezogen werden.

Die Hydrophilie einer Oberfläche kann durch physikalische Methoden, beispielsweise Plasmabehandlung, oder durch chemische Methoden, beispielsweise durch Oberflächenreaktionen, eine Belegung oder einer Einlagerung einer chemischen Verbindung, modifiziert werden.

Die Hydrophilie einer Oberfläche eines thermoplastischen Kunststoffes wie PEEK kann durch direkte Gasphasenfluorierung erhöht werden. Beispielsweise kann die Oberfläche eines Körpers aus PEEK durch Behandlung mit einem Gasgemisch aus Fluor und Luft behandelt werden, wobei das Gasgemisch einen Fluorgehalt von 5 mol% Fluor aufweisen kann.

Oberflächen können auch unter Verwendung eines Lasers hydrophilisiert werden. So können Oberflächen von metallischen Werkstoffen oder Keramiken mit Hilfe eines Lasers in Luftatmosphäre gereinigt werden, was zu einer hydrophileren Oberfläche führt. Eine Hydrophilisierung einer Oberfläche kann auch unter Verwendung eines Lasers und einer Silikatisierungsflüssigkeit erfolgen, wodurch die Oberfläche gereinigt und zusätzlich funktionalisiert wird. Dies führt dazu, dass die behandelte Oberfläche noch hydrophiler wird. Die Silikatisierung mittels Laser kann in einem Tauchbad durchgeführt werden.

Eine periodische Mikrostruktur im Sinne der vorliegenden Erfindung ist eine Struktur an der Oberfläche eines Körpers, mit Erhebungen und/oder Vertiefungen, wobei die Erhebungen und Vertiefungen regelmäßig angeordnet sind. Vorzugsweise erfolgt der Schritt der Mikrostrukturierung vor dem Schritt der Oberflächenhydrophilierung. Dadurch kann sichergestellt werden, dass auch die Vertiefungen der Mikrostruktur, die durch Entfernung von Material erzeugt werden, die gewünschten hydrophilen Oberflächeneigenschaften aufweisen.

Die periodische Mikrostruktur wird vorzugsweise mittels direkter Laserstrahlinterferenzstrukturierung (Direct Laser Interference Patterning (DLIP)), erzeugt. DLIP ist eine laserbasierte Technologie, welche das physikalische Prinzip der Interferenz von hochintensiven kohärenten Laserlichtstrahlen nutzt, um funktionelle periodische Mikrostrukturen herzustellen. Dieses Verfahren wird beispielsweise von T. Kunze et al. im Artikel "Direct laser interference patterning: from fundamentals to industrial applications", Lasers in Manufacturing Conference 2017 beschrieben. Dabei werden Interferenzmuster durch Aufspaltung eines kohärenten Laserstrahls, beispielsweise mit Hilfe von Strahlteilern, in zwei oder mehr Teilstrahlen erzielt, die dann am Werkstück mit Hilfe mehrerer Spiegel überlagert werden. Die Interferenz mehrerer Laserstrahlen führt zu einer effektiven Modulation des Laserintensitätsprofils. Die Muster können direkt auf jedes Material übertragen werden, das die Energie des Lasers bei der gewählten Wellenlänge absorbiert. Der Strukturierungsprozess basiert auf photothermischen, photophysikalischen oder photochemischen Mechanismen, je nach Art des Materials.

Vorzugsweise besteht die Oberfläche des Körpers der erfindungsgemäßen Vorrichtung aus einem thermoplastischen Kunststoff oder ist mit einem thermoplastischen Kunststoff beschichtet. Besonders bevorzugt ist der thermoplastische Kunststoff ein Polyaryletherketon, am meisten bevorzugt ein Polyetheretherketon (PEEK). Zur Bearbeitung dieser Kunststoffe wird vorzugsweise ein infraroter Ultrakurzpulslaser mit einer Pulsdauer von nicht mehr 500 ps, vorzugsweise nicht weniger als 5 ps und nicht mehr als 100 ps, und ein Interferenzmodul des Typs CORErapid IR30.4 des Herstellers Fusion Bionic eingesetzt.

Die periodische Mikrostruktur hat vorzugsweise eine Profilhöhe oder Profiltiefe von nicht weniger als 0,1 µm und nicht mehr als 50 µm, besonders bevorzugt nicht weniger als 0,5 µm und nicht mehr als 20 µm, am meisten bevorzugt nicht weniger als 1 µm und nicht mehr als 10 µm. Die Begriffe Profilhöhe und Profiltiefe werden synonym verwendet. Die Profilhöhe oder Profiltiefe ist dabei die Höhendifferenz zwischen den regelmäßig angeordneten Erhebungen und Vertiefungen, in einer Richtung senkrecht zur Oberfläche, welche die Mikrostruktur aufweist.

Wenn die Profiltiefe der periodischen Mikrostruktur in diesem Bereich liegt, wurde ein positiver Effekt auf die Entfernung von Flüssigkeitsresten beobachtet. So wurde beobachtet, dass Flüssigkeitsreste an den Kontaktpunkten zwischen den scheibenförmigen Substraten und den Auflageposition des Körpers der erfindungsgemäßen Vorrichtung besser auf die an die Auflagepositionen angrenzenden, abfallenden Flächen des Körpers übertragen und über diese vom Körper abgeführt werden können, wenn diese Flächen mit einer Mikrostruktur mit einer Profiltiefe im oben genannten Bereich versehen sind. Die Übertragung von Flüssigkeitsresten von einem scheibenförmigen Substrat auf den Körper der Vorrichtung zum Trockenen und die Entfernung der übertragenen Flüssigkeitsreste vom Körper ist besonders gut, wenn die periodische Mikrostruktur eine Profiltiefe von nicht weniger als 1 µm und nicht mehr als 10 µm aufweist.

Die periodische Mikrostruktur besteht bevorzugt aus parallel angeordneten Vertiefungen und Erhöhungen, kreisförmigen Vertiefungen oder kreisförmigen Erhöhungen. Eine periodische Mikrostruktur aus parallel angeordneten Vertiefungen ist besonders bevorzugt. Die Vertiefungen sind vorzugsweise als Kanäle mit einer Breite von nicht weniger als 1 µm und nicht mehr als 50 µm, besonders bevorzugt als Kanäle mit einer Breite von nicht weniger als 1 µm und nicht mehr als 30 µm, am meisten bevorzugt als Kanäle mit einer Breite von nicht weniger als 5 µm und nicht mehr als 20 µm, ausgestaltet. Durch Kapillarkräfte können Flüssigkeitsreste, beispielsweise Wassertropfen, von den Kanälen aufgenommen und entlang dieser vom Körper der erfindungsgemäßen Vorrichtung abgeleitet werden. Der Transport von Flüssigkeitsresten entlang der Kanäle mit Hilfe von Kapillarkräften ist besonders effizient, wenn die Kanäle eine Breite von nicht weniger als 1 µm und nicht mehr als 50 µm aufweisen. Der Transport von Flüssigkeitsresten entlang der Kanäle kann weiter verbessert werden, wenn die Kanäle eine Breite von nicht weniger als 5 µm und nicht mehr als 20 µm aufweisen. Die parallel angeordneten Vertiefungen und Erhöhungen einer periodischen Mikrostruktur, die parallel verlaufende Kanäle umfasst, sind vorzugsweise aus der Horizontalen geneigt, so dass Flüssigkeitsreste, insbesondere Wassertropfen, zusätzlich zu den Kapillarkräften auch mit Hilfe der Schwerkraft entlang der Vertiefungen abgeleitet werden können. Vorzugsweise sind die Kanäle senkrecht zur Haupterstreckungsrichtung angeordnet. In einer bevorzugten Ausführungsform besteht die periodische Mikrostruktur aus parallel angeordneten Kanälen.

Die periodische Mikrostruktur hat vorzugsweise eine Periode von nicht weniger als 1 µm und nicht mehr als 500 µm, besonders bevorzugt nicht weniger als 5 µm und nicht mehr als 100 µm, am meisten bevorzugt nicht weniger als 10 µm und nicht mehr als 50 µm. Die Periode entspricht dabei vorzugsweise dem Betrag des kleinsten Translationsvektors in einer Richtung, entlang der sowohl Vertiefungen als auch Erhebungen angeordnet sind. In einer bevorzugten Ausführungsform entspricht die Periode dem Abstand zwischen den regelmäßig angeordneten Erhebungen oder dem Abstand zwischen den regelmäßig angeordneten Vertiefungen. Es wurde festgestellt, dass die Kapillarkräfte und damit die Übertragung und Entfernung von Flüssigkeitsresten vom Substrat über den Körper und von diesem weg, weiter verbessert werden kann, wenn die Periode der periodischen Mikrostruktur in dem oben angegebenen Bereich liegt. Bei einer Periode von nicht weniger als 10 µm und nicht mehr als 50 µm kann der Übergang von Flüssigkeitsresten von den Substraten auf die Auflagepositionen des Körpers, und das Abfließen dieser Flüssigkeitsreste von den Auflagepositionen weg, weiter verbessert werden. Profiltiefe, Periode und Ausdehnung von Erhöhungen und Vertiefungen der periodischen Mikrostruktur können unter anderem mittels Rasterkraftmikroskopie bestimmt werden.

Gemäß dem zweiten Aspekt ist die vorliegende Erfindung auf ein Verfahren zum Trocknen von scheibenförmigen Substraten, die in eine Flüssigkeit getaucht sind, gerichtet. Das Verfahren umfasst die folgenden Schritte:
das Positionieren der in die Flüssigkeit getauchten, scheibenförmigen Substrate auf der Vorrichtung gemäß dem ersten Aspekt der vorliegenden Erfindung; und
das Überführen der scheibenförmigen Substrate mit der Vorrichtung aus der Flüssigkeit in einen Gasraum enthaltend einen Dampf, der auf den scheibenförmigen Substraten nicht kondensiert und die Oberflächenspannung von Flüssigkeitsresten, die an den scheibenförmigen Substraten haften, herabsetzt.

In diesem Verfahren können Flüssigkeitsreste von den scheibenförmigen Substraten über die an die Auflagepositionen angrenzenden, nach unten geneigten Flächen des Körpers der Vorrichtung ablaufen und so entfernt werden. Es kann also darauf verzichtet werden, die Flüssigkeitsreste zwischen den scheibenförmigen Substraten und den Scheibenhalter aktiv zu entfernen.

Ein Dampf, der nicht auf den Substraten kondensiert, hat einen Dampfdruck, der bei der Temperatur des Bades und der Substrate nicht gesättigt ist, während ein Dampf, der auf den Substraten kondensiert, einen solchen gesättigten Dampfdruck hat. Die Substrate können in verschiedenen Flüssigkeitsbädern behandelt werden. Wenn das Reinigungsbad Wasser enthält, wird vorzugsweise der Dampf eines organischen Lösungsmittels, vorzugsweise eine oder mehrere Verbindungen ausgewählt aus Alkoholen, Glykolen, Aldehyden, Estern, Ketonen oder Tetrahydrofuran, verwendet. Das erfindungsgemäße Verfahren kann auch dann angewendet werden, wenn das Bad andere polare Flüssigkeiten, beispielsweise Alkohole, enthält. Die Substrate können dann beispielsweise direkt aus dem Alkohol mit dem Dampf des organischen Lösungsmittels 1,1,1-Trifluortrichlorethan in Kontakt gebracht werden.

Dadurch, dass zumindest ein Teil der an die Auflagepositionen angrenzenden, abfallenden Flächen zumindest in einem Teil ihres oberen Abschnitts hydrophil ist und eine periodische Mikrostruktur aufweist, können wässrige Flüssigkeitsreste oder Flüssigkeitsreste mit polaren Lösungsmittelanteilen, die sich am unteren Rand der scheibenförmigen Substrate angesammelt haben, an den Auflagepositionen leichter auf den Körper übergehen und anschließend von den Flächen abgeführt und in das Flüssigkeitsbad zurückgeführt werden.

### Beschreibung von Ausführungsbeispielen und Vergleichsbeispielen

In den Ausführungsbeispielen 1 bis 4 wurde jeweils eine erfindungsgemäße Vorrichtung wie in Fig. 1 dargestellt zur Trocknung von 50 Scheiben aus einkristallinem Silizium mit einem Durchmesser von 300 mm und einer Dicke von 750 µm verwendet. Der Körper (1) der Vorrichtung verjüngte sich nach oben zu einem Kantenprofil (6) mit Zick-Zack-Form entlang der Haupterstreckungsrichtung (2) (siehe Fig. 2b und Fig. 2c). Der Körper (1) bestand aus PEEK. Mittels direkter Laserinterferenzstrukturierung (DLIP) wurde auf einem Teil (7) des oberen Abschnittes der an die Auflagepositionen (5) des Körpers (1) angrenzenden, abfallenden Seitenflächen eine periodische Mikrostruktur mithilfe eines infraroten Ultrakurzpulslasers mit einer Wellenlänge von 1064 nm und einer Pulsdauer von 12 ps, und einem Interferenzmodul des Typs CORErapid IR30.4 des Herstellers Fusion Bionic erzeugt.

Im Ausführungsbeispiel 1 wurde eine periodische Mikrostruktur aus kreisförmigen Vertiefungen mit einer Profiltiefe von 10 µm und einer Periode von 21 µm erzeugt. Fig. 3a zeigt rasterkraftmikroskopische Aufnahmen dieser periodische Mikrostruktur.

Im Ausführungsbeispiel 2 wurde eine periodische Mikrostruktur aus kreisförmigen Erhöhungen mit einer Profiltiefe von 1 µm und einer Periode von 21 µm erzeugt. Fig. 3b zeigt rasterkraftmikroskopische Aufnahmen dieser periodische Mikrostruktur.

Im Ausführungsbeispiel 3 wurde eine periodische Mikrostruktur aus Kanälen mit einer Profiltiefe von 10 µm und einer Periode von 21 µm erzeugt. Fig. 3c zeigt rasterkraftmikroskopische Aufnahmen dieser periodische Mikrostruktur.

Im Ausführungsbeispiel 4 wurde eine periodische Mikrostruktur aus Kanälen mit einer Profiltiefe von 5 µm und einer Periode von 21 µm erzeugt. Fig. 3d zeigt rasterkraftmikroskopische Aufnahmen dieser periodische Mikrostruktur.

Anschließend erfolge jeweils eine Hydrophilierung der mit der periodischen Mikrostruktur versehenen Seitenflächen, wobei diese mit einem Gasgemisch aus 5 mol% Fluor und Luft als Spülgas behandelt wurden.

Somit unterschieden sich die in den Ausführungsbeispielen 1 bis 4 hergestellten Körper ausschließlich in der Geometrie/dem Muster der periodischen Mikrostruktur und deren Profiltiefe.

Im Vergleichsbeispiel 1 wurde die gleiche Vorrichtung wie im Ausführungsbeispiel verwendet, mit der Ausnahme, dass die abfallenden Flächen des Körpers der Vorrichtung nicht mit einer Mikrostruktur versehen wurden. Ansonsten wurde genau wie im Ausführungsbeispiel verfahren.

Im Vergleichsbeispiel 2 wurde dieselbe Mikrostruktur wie im Ausführungsbeispiel 1 erzeugt, jedoch auf eine anschließende Hydrophilierung durch Behandlung mit einem Gasgemisch aus Fluor und Luft verzichtet.

Die in den Ausführungsbeispielen 1 bis 4 und in den Vergleichsbeispielen 1 und 2 hergestellten Körper wurden anschließend zur Trocknung verwendet. Dafür wurden jeweils 50 Scheiben auf der oberen Kante in Querrichtung zur Haupterstreckungsrichtung der Vorrichtung stehend, aus einem mit Wasser gefüllten Becken in einen Gasraum mit Isopropanol-Dampf überführt.

Die getrockneten Halbleiterscheiben wurden im Bereich der Auflagepositionen auf dem Körper auf das Vorhandensein von Partikeln untersucht. Der Vergleich der Ausführungsbeispiele 1 bis 4 mit den Vergleichsbeispielen 1 und 2 zeigte, dass die mit der erfindungsgemäßen Vorrichtung und gemäß dem erfindungsgemäßen Verfahren durchgeführte Trocknung in den Ausführungsbeispielen 1 bis 4 zu erheblich weniger Rückständen auf den getrockneten Scheiben führte. Die wenigsten Rückstände wurden dabei in den Ausführungsbeispielen 3 und 4 beobachte, wobei das Ausführungsbeispiel 4 die besten Ergebnisse lieferte. Dies zeigte zum einen, dass eine Mikrostruktur mit Kanälen Flüssigkeitsreste besonders gut ableiten kann, und zum anderen, dass Profiltiefen im Bereich von 1 µm bis 10 µm, und insbesondere Profiltiefen von 5 µm, Flüssigkeitsreste besonders gut aufnehmen und von der Auflagefläche ableiten können.

## Patentansprüche

1. Vorrichtung zum Trocknen von scheibenförmigen Substraten (8) umfassend einen Körper (1) mit einer horizontalen Haupterstreckungsrichtung (2) und einem Querschnittsprofil (3) quer zur Haupterstreckungsrichtung (2), das sich in vertikaler Richtung nach oben verjüngt,
wobei der Körper (1) an seiner Oberseite mehrere Auflagepositionen (5) aufweist, die dafür geeignet sind, scheibenförmige Substrate (8) abzustützen,
die mehreren Auflagepositionen (5) entlang der Haupterstreckungsrichtung (2) angeordnet sind,
an die mehreren Auflagepositionen (5) Flächen des Körpers angrenzen, die ausgehend von den Auflagepositionen (5) abfallen, und
zumindest ein Teil der an die Auflagepositionen (5) angrenzenden, abfallenden Flächen zumindest in einem Teil (7) ihres oberen Abschnitts hydrophil ist und eine periodische Mikrostruktur aufweist.

2. Vorrichtung zum Trocknen von scheibenförmigen Substraten gemäß dem Anspruch 1, wobei der hydrophile, obere Abschnitt **dadurch gekennzeichnet ist, dass** ein Wassertropfen auf ihm einen Kontaktwinkel α von nicht mehr als 50° aufweist.

3. Vorrichtung zum Trocknen von scheibenförmigen Substraten gemäß einem der Ansprüche 1 oder 2, **dadurch gekennzeichnet, dass** die periodische Mikrostruktur eine Profiltiefe von nicht weniger als 0,1 µm und nicht mehr als 50 µm aufweist.

4. Vorrichtung zum Trocknen von scheibenförmigen Substraten gemäß einem der Ansprüche 1 bis 3, **dadurch gekennzeichnet, dass** die periodische Mikrostruktur eine Periode von nicht weniger als 1 µm und nicht mehr als 500 µm aufweist.

5. Vorrichtung zum Trocknen von scheibenförmigen Substraten gemäß einem der Ansprüche 1 bis 4, **dadurch gekennzeichnet, dass** die periodische Mikrostruktur parallel angeordnete Kanäle mit einer Breite von nicht weniger als 1 µm und nicht mehr als 50 µm umfasst.

6. Vorrichtung zum Trocknen von scheibenförmigen Substraten gemäß einem der Ansprüche 1 bis 5, **dadurch gekennzeichnet, dass** der Körper aus einem thermoplastischen Kunststoff besteht oder mit einem thermoplastischen Kunststoff beschichtet ist.

7. Vorrichtung zum Trocknen von scheibenförmigen Substraten gemäß einem der Ansprüche 1 bis 6, **dadurch gekennzeichnet, dass** der thermoplastische Kunststoff ein Polyaryletherketon, vorzugsweise Polyetheretherketon, ist.

8. Vorrichtung zum Trocknen von scheibenförmigen Substraten gemäß einem der Ansprüche 1 bis 7, **dadurch gekennzeichnet, dass** die Auflagepositionen so ausgestaltet sind, dass die darauf abgestützten scheibenförmigen Substrate quer zur Haupterstreckungsrichtung angeordnet sind.

9. Vorrichtung zum Trocknen von scheibenförmigen Substraten gemäß einem der Ansprüche 1 bis 8, **dadurch gekennzeichnet, dass** sich der Körper in vertikaler Richtung nach oben zu einer Kante oder einem Kantenprofil verjüngt.

10. Vorrichtung zum Trocknen von scheibenförmigen Substraten gemäß einem der Ansprüche 1 bis 9, wobei jede Auflageposition durch einen Knick im Kantenprofil gekennzeichnet ist.

11. Vorrichtung zum Trocknen von scheibenförmigen Substraten gemäß einem der Ansprüche 1 bis 10, **dadurch gekennzeichnet, dass** der Körper so ausgebildet ist, dass die scheibenförmigen Substrate an den Auflagepositionen auf dem höchsten Punkt des jeweiligen Querschnittsprofils aufliegen.

12. Verfahren zum Trocknen von scheibenförmigen Substraten, die in eine Flüssigkeit getaucht sind, umfassend
das Positionieren der in die Flüssigkeit getauchten, scheibenförmigen Substrate auf der Vorrichtung gemäß einem der Ansprüche 1 bis 11; und
das Überführen der scheibenförmigen Substrate mit der Vorrichtung aus der Flüssigkeit in einen Gasraum enthaltend einen Dampf, der auf den scheibenförmigen Substraten nicht kondensiert und die Oberflächenspannung von Flüssigkeitsresten, die an den scheibenförmigen Substraten haften, herabsetzt.

13. Verfahren zum Trocknen von scheibenförmigen Substraten gemäß dem Anspruch 12, umfassend,
das Entfernen von Flüssigkeitsresten zwischen den scheibenförmigen Substraten und dem Körper der Vorrichtung über die an die Auflagepositionen angrenzenden, abfallenden Flächen des Körpers der Vorrichtung.

14. Verfahren zum Trocknen von scheibenförmigen Substraten gemäß dem Anspruch 13, **dadurch gekennzeichnet, dass** darauf verzichtet wird, die Flüssigkeitsreste zwischen den scheibenförmigen Substraten und dem Körper der Vorrichtung aktiv zu entfernen.
